Europäisches Patentamt

(19) European Patent Office  (11) Publication number: **0 104 998**
Office européen des brevets  **A2**

(12) **EUROPEAN PATENT APPLICATION**

(21) Application number: 83401854.1  (51) Int. Cl.³: **G 01 R 21/00**

(22) Date of filing: 23.09.83

(30) Priority: 24.09.82 US 423398

(43) Date of publication of application:
04.04.84 Bulletin 84/14

(84) Designated Contracting States:
DE FR GB IT NL

(71) Applicant: SANGAMO WESTON, INC.
180 Technology Drive
Norcross Georgia 30092(US)

(72) Inventor: Randall, Bruce E.
15440 Hopewell Road
Alpharetta Georgia 30201(US)

(74) Representative: Chareyron, Lucien et al,
Schlumberger Limited 42, rue Saint-Dominique
F-75340 Paris Cedex 07(FR)

(54) Quasi-asynchronous sampling method and system.

㊐ K samples of L successive cycles of an electrical signal that is at least approximately periodic are taken, where K = LN + D, to cause corresponding samples of successive cycles to unidirectionally drift. The value of N defines the number of samples per waveform cycle, the value of D is related to drift sampling rate. Unidirectional sampling drift ensures that all points on the signal wave form over a number of cycles are sampled to avoid missing a periodic waveform characteristic that might tend to occur between samples. Since the sampling rate is synchronized to L cycles of the input signal, the number of samples per cycle of the input signal is substantially constant as a function of input signal frequency. Quasi-asynchronous sampling in accordance with the invention is particularly useful for making electrical power line measurements in environments where power line frequency tends to vary.

FIG. 3

0460B/44 .358/9-23-82

QUASI-ASYNCHRONOUS SAMPLING METHOD AND SYSTEM     **0104998**

## Field of the Invention

The present invention is directed generally toward electrical parameter sampling, and more particularly toward a quasi-asynchronous sampling method and system developing unidirectional drift in corresponding samples of successive waveform cycles while maintaining the number of samples per cycle substantially constant as a function of waveform frequency.

## Background Art

In certain types of measurement systems, a repetitive electrical parameter is sampled at a rate that is a function of the required accuracy and the operating speed of the microprocessor signal processing being implemented. In a line power meter, for example, 60 Hz voltage and current measurements are successively sampled, converted to corresponding digital values and multiplied together to obtain instantaneous power "samples". Successive instantaneous power samples are thereafter integrated and divided by the integration period to obtain average power.

Waveform sampling is typically synchronous, that is, the samples are "stationary" with respect to successive cycles. A practical number of samples taken per each cycle of an input waveform in a typical line power meter using a microprocessor for processing samples is on the order of 16. It can thus be appreciated that power line disturbances, such as "glitches", appearing from time to time on the power line have a tendency to become hidden between successive samples and thereby be non-contributive to the power measurement, creating error.

To ensure that all parts of the waveform are sampled over a given period of time, sampling has in some systems been made asynchronous relative to the waveform being measured, so that the samples appear to "drift" across the waveform. Since this form of sampling is not related to waveform frequency, however, the number of samples per cycle of the waveform varies with the frequency of the waveform. If applied to a line power measurement meter, for

**0104998**

example, a meter calibrated to operate with a 60 Hz power line cannot be used, without recalibration, on a European power line that is typically operated 50 Hz, and cannot be used at all in applications wherein the power frequency tends to vary, such as in Mexico. As another problem, asynchronous sampling, being fixed rate, although asynchronous to the nominal frequency of the input signal may be synchronous to an input signal having a slightly different frequency, losing waveform disturbances that occur between samples.

In another form of sampling, a predetermined amount of "dither" is added to the samples causing the samples to oscillate about the nominal sampling points within the waveform. Dither sampling is sometimes made asynchronous to the input waveform, and even if made synchronous, may have a tendency to miss regions of the waveform since the dithered samples do not drift completely across the waveform.

## Disclosure of the Invention

A general object of the present invention is to provide a waveform sampling method and system, wherein corresponding samples of successive cycles unidirectionally drift to sample a range of points across the entire waveform over a number of successive cycles such that sampling is synchronized to a relatively large number of waveform cycles, but sampling appears to be asynchronous within adjacent cycles.

An electrical waveform sampling system in accordance with one aspect of the invention involves a circuit for sampling an input electrical parameter including means for monitoring the input parameter, means responsive to said monitoring means for developing signals synchronous to L (L is greater than 1) integral cycles of said input parameter, but asynchronous to any single integral cycle of said parameter, and means responsive to said signals for controlling sampling of said input parameter to cause corresponding samples of successive cycles of said input parameter to unidirectionally drift.

An electrical waveform sampling method in accordance with another aspect of the invention involves sampling an input electrical parameter including monitoring successive cycles of said input parameter, developing signals in response to said monitoring synchronous to L (L is greater than one) integral cycles of said input parameter but asynchronous to any single integral cycle of said parameter, and sampling said input parameter in response to said signals such that corresponding samples of said successive cycles of said input parameter are caused to unidirectionally shift.

An electrical waveform sampling method and system in accordance with another aspect of the invention involves synchronizing sampling to an integral number of waveform cycles but wherein the number of samples is not an integral multiple of the number of cycles. The number of samples, K, taken over L cycles of an input signal waveform is defined by the following equation:

$$K = LN + D, \text{ wherein } K, L \text{ and } N \text{ are integers.}$$

In a 60 Hz line power measurement meter, the following values are preferred:

$$L = 60, N = 16, D = 1, K = 961$$

In this example, 16 samples are taken of each waveform, and the samples unidirectionally traverse across the waveform over a time interval corresponding to 60 waveform·cycles.

Still other objects and advantages of the present invention will become readily apparent to those skilled in this art from the following detailed description, wherein I have shown and described only the preferred embodiment of the invention, simply by way of illustration of the best modes contemplated by me of carrying out my invention. As will be realized, the invention is capable of other and different embodiments, and its several details are capable of modification in various, obvious respects, all without departing from the invention. Accordingly, the drawings and description are to be regarded as illustrative in nature, and not as restrictive.

Brief Description of the Drawing Figures.

Figure 1 is a drawing showing 60 consecutive waveform cycles being sampled using quasi-asynchronous sampling in accordance with the invention;

Figure 2 shows a single cycle of the waveform shown in Figure 1, illustrating in more detail unidirectional sample drift;

Figure 3 is a simplified block diagram showing a circuit for measuring an electrical signal using quasi-asynchronous sampling;

Figure 4 is a diagram showing a phase locked loop circuit for controlling quasi-asynchronous sampling; and

Figure 5 is a circuit diagram showing a three phase line power measurement meter using quasi-asynchronous sampling, in accordance with the invention.

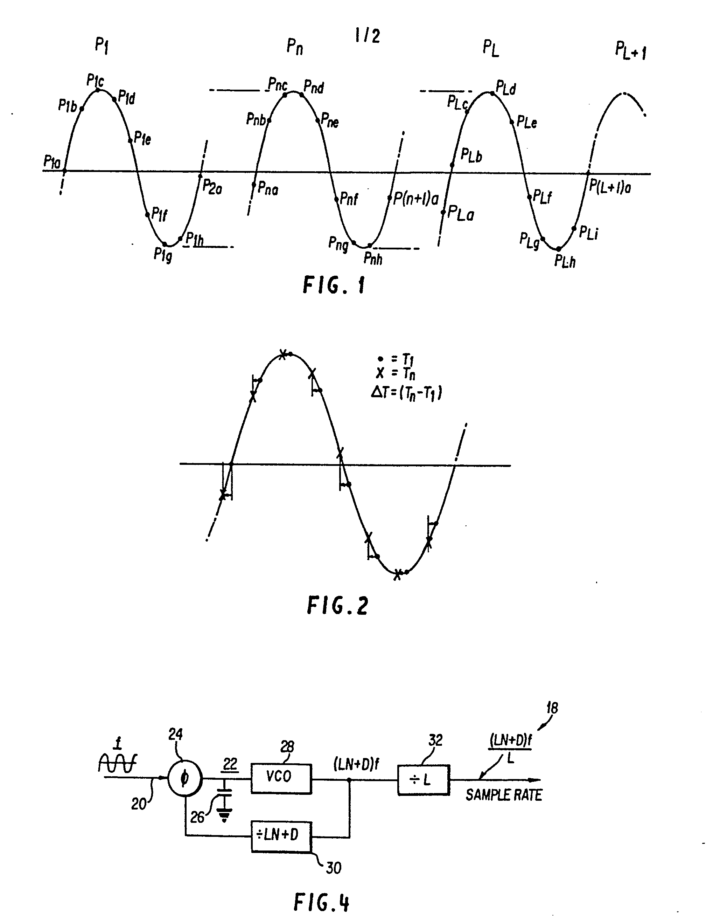

Quasi-asynchronous sampling, in accordance with the invention, is asynchronous with respect to each cycle of the waveform to develop sample drift while being synchronous to a relatively large number of waveform cycles to enable the sampling rate to track the waveform frequency. To help understand quasi-asynchronous sampling, Figure 1 shows a series of L successive cycles $(P_1 \ldots P_n \ldots P_L)$ of a signal waveform to be measured. Eight samples of each waveform cycle are taken, to be integrated or otherwise processed in a microprocessor or with other circuitry, to obtain the average value of a parameter associated with the waveform or to obtain other information concerning that parameter.

The eight samples $P_{1a} \ldots P_{1h}$ taken of the first cycle $P_1$ are equally spaced along the waveform with the first sample $P_{1a}$ occurring at the leading zero crossover point. The position of this first sample is arbitrary, but has been selected as the leading zero crossover point of the waveform as a matter of convenience for the purpose of this discussion. Samples $P_{1b}$, $P_{1c}$, and $P_{1d}$ are on the positive half of the cycle, whereas the remaining samples $P_{1e}$, $P_{1f}$, $P_{1g}$ and $P_{1h}$ are on the negative half cycle of the signal waveform. The last sample $P_{1h}$ is on the negative half cycle just leading the point at which the last sample would be taken if the samples were synchronous over each cycle. Accordingly, $P_{1h}$ is leading the point one sample space before the trailing zero crossover point of the cycle. There are thus eight samples taken of this cycle $P_1$, with the samples spanning slightly less than $315^O$ of the waveform cycle. $P_{2a}$, just leading the leading zero crossover point of cycle $P_2$, is considered to be on cycle $P_2$ for the purposes of this description.

Referring now to waveform $P_n$, the first sample $P_{na}$ phase leads the corresponding sample $P_{1a}$ of the first cycle of the waveform, the second sample $P_{nb}$ phase leads the corresponding second sample $P_{1b}$ of waveform cycle $P_1$, and so on. The samples associated with waveform $P_n$ have thus phase shifted, or drifted, relative to corresponding samples of the first waveform sample $P_1$, by the amount $\Delta T$, as shown in Figure 2.

In waveform cycle, $P_L$, which is the last waveform cycle of the series, there is further phase shift or drift of the samples. Fig. 1 depicts the sample points occuring where one additional sample point is added over L cycles to the set of sample points occuring where sampling is synchronous over each cycle. Accordingly, $P_{Lh}$ is phase shifted to a point just trailing the point on $P_L$ corresponding with $P_{1g}$. $P_{Li}$ is an additional point just trailing the point on $P_L$ corresponding with $P_{1h}$. The initial sample of waveform $P_{(L+1)}$ is synchronized to the trailing zero crossover point of the preceding waveform cycle.

$P_L$. The sample points of waveform cycle $P_{(L+1)}$ are thus coincident with corresponding samples of the initial cycle $P_1$ of the series. In other words, corresponding samples of successive waveforms have drifted unidirectionally through one complete waveform cycle over a duration corresponding to L waveform cycles. Sampling is synchronous relative to L waveform cycles but asynchronous between successive cycles, accounting for the drift.

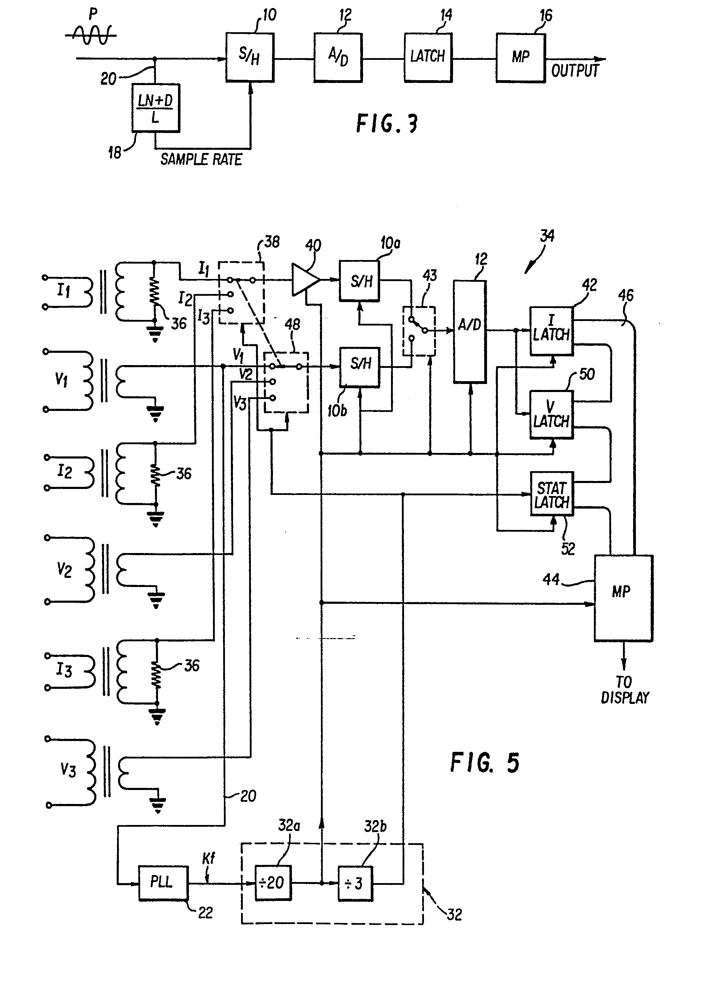

Quasi-asynchronous sampling is implemented by the circuit shown in block diagram form in Figure 3, wherein input signal waveform P is sampled by sample and hold circuit (S/H) 10. Samples of the waveform P are converted to corresponding digital signals in analog-to-digital converter 12. These digital signals are latched in binary latch 14 to be supplied to microprocessor 16 for scaling, integration and other signal processing.

Sampling is controlled by control circuit 18 synchronized to the signal waveform P at line 20. Circuit 18, which is preferably a phase locked loop, develops K sample pulses over a predetermined sampling period of L cycles, the quantity K being defined by the following equation:

$$K = LN + D$$

where

L is an integral number of cycles of the input signal waveform to correspond to $360^{\circ}$ of sample drift;

N is the number of samples per signal waveform cycle (N being an integer); and

D is an integer having an absolute value $\ll$ L and which corresponds to sample drift intervals.

In a 60 Hz commercial power line environment, preferred values for L, N and D are, respectively, 60, 16 and 1, whereby K = 961. Thus, each power line cycle is sampled 16 times, and the sample locations on each cycle are repeated following each 60 cycle sequence; this occurs each 1 second of time.

Referring to Figure 4, the sample control circuit 18 comprises a conventional phase locked loop circuit 22 having, in a forward loop, a phase detector 24, an integrator 26 and a voltage controlled oscillator (VCO) 28. A frequency divider 30 is in a feedback loop between the output of VCO 28 and one input of phase detector 24. The divider circuit 30 is a divide by $LN + D$ divider circuit, whereby the VCO 28 tracks the input signal P and is a frequency $(LN + D)f$, where f is the frequency of the input signal waveform P. In a commercial 60 Hz power line environment, where $K = LN + D = 961$ in accordance with the present example, VCO 28 develops 961 pulses for every integral cycle of input signal waveform P. The output of VCO 28 is applied to a divide by L divider 32, which develops $LN + D$ pulses over a duration of L cycles of the input signal waveform P. This is the sampling pattern shown in Figure 1 providing quasi-asynchronous sampling. In the 60 Hz commercial power line example, divider 32 develops 961 sample pulses per 60 line cycles which, when applied to sample line voltage, load current or other power line related characteristics, will develop the unidirectional sample drift shown in Figure 2.

Figure 5 shows a circuit embodying the principles of the invention to a microprocessor controlled, three-phase power line measuring instrument. The front end of circuit 34 includes phase current transformers $I_1$, $I_2$ and $I_3$ and phase voltage transformers $V_1$, $V_2$ and $V_3$ respectively applied to the three line phases to be measured. The secondary circuits of the current transformers $I_1$, $I_2$ and $I_3$ are provided with burden resistors 36 to convert the secondary circuit currents into properly scaled voltages. These scaled voltages are applied to a first sample and hold circuit 10a through an analog switch 38 and a buffer 40. The switch 38 is controlled to sample the outputs of the three phase current transformers $I_1$, $I_2$ and $I_3$ in succession. These three current measurements are passed through analog switch 43 to converter 12 to be digitized, stored in current latch 42 and thereafter transferred to microprocessor 44 along bus 46.

Similarly, phase voltages developed by voltage transformers $V_1$, $V_2$ and $V_3$ are sampled successively by an analog switch 48 to be supplied in sequence directly to sample and hold circuit 10b and thereafter transferred to converter 12 through switch 43. The digitized phase voltage values in converter 12 are supplied to microprocessor 44 through voltage latch 50 and along bus 46.

A. status latch 52 supplies to microprocessor 44 a flag · identifying to coordinate particular phases with voltage or current data being received by the microprocessor.

Phase locked loop 22 is synchronized to the signal waveform P at the secondary of voltage transformer $V_1$ along line 20. The phase locked loop 22 could optionally, of course, be synchronized to any one of the other voltage phases.

The output of phase locked loop 22 is applied to divider 32 which, in this example, is formed of two successive dividers 32a, 32b. The divider 32 is a divide by 60 divider, formed by a first divide by 20 divider 32 and a second divide by 3 divider 32b.

The output of divider 32a controls latching of the current and voltage latches 42, 50 and controls the toggling of analog switch 43 alternately between the outputs of sample and hold circuits 10a, 10b. Divider 32a also controls sampling by sample and hold circuits 10a and 10b and controls analog-to-digital conversion by converter 12. Divider 32b controls the indexing of analog switches 38 and 48.

Current and voltage sampling for the three phases is performed as follows.

Initially, switches 38, 43 and 48 are in the positions shown in Fig. 5, to apply phase current $I_1$ through buffer 40 to sample and hold circuit 10a and converter 12. The output of converter 12 (representing phase current $I_1$) is applied to latch 42. Switch 43 is then toggled to its other position to thereby cause voltage $V_1$ (associated with current $I_1$) to be applied to sample and hold circuit 10b and converter 12. The output of converter 12 (representing phase voltage $V_1$) is applied to latch 50. Upon the next sample, switches 38 and 48 are indexed to positions $I_2$ and $V_2$, respectively, to sample the second phase current and voltage, followed by an indexing to positions $I_3$ and $V_3$ on the third sample. During each phase sample ($I_1, V_1$; $I_2, V_2$; $I_3, V_3$) switch 43 is alternately toggled between the output of sample and hold circuits 10a and 10b to converter 12. Sample and hold circuits 10a and 10b hold current and voltage samples taken at the same point in time from the particular phase being measured of input waveform P. These samples must be taken at the same time in order to ensure accurate measurement of power for each phase.

During each of the three phase samples of current and voltage, current latch 42 and voltage latch 50 are loaded and samples are sequentially transferred along bus 46 to microprocessor 44. The output of status latch 52 (which indicates which phase the particular current and voltage sample is associated with) is also transferred to microprocessor 44 along the bus 46.

The output of divider 32a is a 961 pulse per 20 input signal waveform cycle signal and enables the microprocessor to be synchronized to sample data as it is obtained in real time. The output of divider 32b is a 961 pulse per 60 cycle signal, which identifies the particular phase being monitored, with this information being applied to status latch 52.

Thus, the circuit 34 makes three phase voltage and current measurements by sampling three phase voltages and currents to develop instantaneous analog values in sample and hold circuits 10a, 10b. Samples are converted to corresponding digital values in converter 12 and applied to microprocessor 44 for scaling for multiplication to obtain instantaneous power, and for integration and time division to obtain average power. Of particular importance, however, is the quasi-asynchronous sampling, which enables samples to unidirectionally drift across the waveform to ultimately measure all parts of the waveform, and to track waveform frequency, providing essentially the same number of samples per cycle of the waveform as a function of the frequency of the waveform.

In this disclosure, there is shown and described only the preferred embodiments of the invention, but as aforementioned, it is to be understood that the invention is capable of use in various other combinations and environments and is capable of changes or modifications within the scope of the inventive concept as expressed herein. For example, the quasi-asynchronous sampling scheme could be readily adapted to single phase or N-phase electrical transmission systems.

44.358

0104998

Claims:

1. A circuit for sampling an input electrical parameter characterized by:

means for monitoring the input parameter;

means responsive to said monitoring means for developing signals synchronous to L (L is greater than 1) integral cycles of said input parameter, but asynchronous to any single integral cycle of said parameter; and

means responsive to said signals for controlling sampling of said input parameter to cause corresponding samples of successive cycles of said input parameter to unidirectionally drift.

2. The circuit of claim 1 characterized in that the signals developed by said signal developing means have a repetition rate K defined by the following equation:

$K = LN + D$

where

L is a predetermined integral number greater than 1 of cycles of said input parameter;

N is an integer greater than 1 related to the number of samples/cycle; and

D is an integer whose absolute value is $\ll L$;

and

said sampling is controlled at said repetition rate of said signals.

3. The circuit of claim 2 characterized in that said input parameter is associated with a commercial power line and said signals developed by said signal developing means comprise a pulse train having said repetition rate K with D = 1.

4. The circuit of claim 3 characterized in that said input parameter has a nominal frequency of 50-60Hz and said pulse train is quasi-asynchronous to said input parameter, having said repetition rate K, with L = 60 and N = 16, equal to 961 pulses per 60 cycles of said input parameter, and being synchronized to successive 60 cycle sequences of said input parameter.

0104998

5. The circuit of any one of claims 1 to 4 characterized in that said signal developing means includes means synchronized to said parameter for generating a signal having a repetition rate that is an integral multiple of the repetition rate of said input parameter.

6. The circuit of any one of claims 2 to 4 characterized in that said signal developing means includes means synchronized to said input parameter for generating a signal having a repetition rate equal to K.

7. The circuit of claim 6 characterized in that said signal developing means comprises a phase locked loop.

8. The circuit of claim 6 characterized in that said monitoring means includes means for monitoring P phases, where P is an integer greater than 1, of said input parameter and said controlling means successively samples said phases, and characterized by means responsive to said controlling means for generating analog signals having amplitudes proportional to sampled amplitudes of said phases, means for converting said analog signals to corresponding digital signals, means for processing said digital signals, and means for displaying said processed digital signals.

9. The circuit of claim 8 characterized in that said monitoring means includes transformer means.

10. The circuit of claim 8 characterized in that said signal processing means comprises integration means for integrating samples of each phase of said input parameter.

11. The circuit of claim 7 and claim 10 characterized in that said controlling means comprises pulse divider means responsive to said phase locked loop for controlling samples taken of each phase of said input parameter.

12. The circuit of claim 10 characterized in that said integration means comprises microprocessor means.

13. A method of sampling an input electrical parameter, characterized by:

monitoring successive cycles of said input paramter;

developing signals in response to said monitoring synchronous to L (L is greater than one) integral cycles of said input parameter but asynchronous to any single integral cycle of said parameter; and

sampling said input parameter in response to said signals such that corresponding samples of said successive cycles of said input parameter are caused to unidirectionally shift.

14. The method of claim 13 characterized in that said sampling is at a repetition rate K defined by the following equation:

$$K = LN + D$$

where

L is a predetermined integral number greater than 1 of cycles of said input parameter;

N is an integer greater than 1 related to the number of samples/cycle; and

D is an integer whose absolute value is $\ll$ L.

15. The method of claim 14 characterized in that said input parameter is associated with a commerical power line having a nominal frequency of 50-60 Hz, and said developing step comprises developing a pulse train that is quasi-asynchronous to said input parameter, having said repetition rate K, with L = 60, N = 16, and D = 1, equal to 961 pulses per 60 cycles of said input parameter, and being synchronized to successive 60 cycle sequences of said input parameter.

16. The method of any one of claims 13 to 15 characterized in that said successive cycles of said input parameter occur in P phases, where P is an integer greater than 1 and said sampling step comprises successively sampling said phases, and characterized by:

generating, in response to said sampling, analog signals proportional to sampled amplitudes of said phases;

converting said analog signals to digital signals;

processing said digital signals; and

displaying the processed digital signals.

17. The method of claim 16 characterized in that said processing step comprises integrating samples of each phase of said input parameter.

18. The method of claim 17 characterized in that said developing means comprises a phase locked loop and said sampling step includes pulse dividing said signals developed by said developing means to control samples taken of each phase of said input parameter.

1/2

FIG. 1

$\bullet = T_1$
$X = T_n$
$\Delta T = (T_n - T_1)$

FIG.2

FIG.4

2/2

FIG. 3

FIG. 5